# EUROPEAN PATENT APPLICATION

(11) **EP 3 567 352 A1**
(43) Date of publication of application: **13.11.2019**
(21) Application number: 17890646.7
(22) Date of filing: 26.12.2017
(51) Int. Cl.: G01J 1/02, G01J 5/02, H01L 37/00, H01L 37/02

(54) **INFRARED SENSOR MOUNTING MEMBER**

(30) Priority: 06.01.2017 JP 2017000949
(71) Applicant: Mitsubishi Materials Corporation, Chiyoda-ku Tokyo 100-8117 (JP)
(72) Inventor: SHIRATA Keiji, Naka-shi Ibaraki 311-0102 (JP); HIRANO Shingo, Naka-shi Ibaraki 311-0102 (JP)
(74) Representative: Hoffmann Eitle
(86) International application number: PCT/JP2017/046574
(87) International publication number: WO 2018/128122

(57) **Abstract**

To provide an infrared sensor mounting member that is able to effectively radiate the heat inside the cavity for housing a heat sensitive element to the outside.

The infrared sensor mounting member of the present invention is able to mount an infrared sensor body 5, which includes an insulating substrate 2 on which heat sensitive elements 3A and 3B and a plurality of the terminal electrodes 4 are formed, on a mounting substrate by fixing it at the upper portion thereof and includes: an insulating mounting member main body 6 and a plurality of conductive terminal members 7 that are attached to the mounting member main body with the upper end thereof being connected to the terminal electrodes while the lower end thereof being connected to the mounting substrate when the infrared sensor mounting member is mounted thereon, wherein the terminal members are made of a material having a higher thermal conductivity than that of the mounting member main body and have terminal pin portions 7a that are laterally projected, and the mounting member main body has terminal member inserting hole portions 6a that are formed on its side into which the terminal pin portions are inserted so as to be fixed, and has the element housing hole part 8 that is formed on the upper portion thereof and arranged directly under the heat sensitive element while being in communication with the terminal member inserting hole portions.

## Description

### BACKGROUND OF THE INVENTION

### Field of the Invention

The present invention relates to an infrared sensor mounting member for supporting an infrared sensor that measures a temperature or the like of an object to be measured by detecting infrared radiation from the object and for then mounting it on a substrate or the like.

### Description of the Related Art

Conventionally, an infrared sensor is used as a temperature sensor for measuring a temperature of an object to be measured by detecting infrared radiation radiated from the object in a non-contact manner.

For example, Patent document 1 discloses an infrared sensor including: an insulating film; first and second heat sensitive elements that are provided so as to be spaced apart from each other on one surface of the insulating film; first and second conductive wiring films that are formed on the one surface of the insulating film and are connected to first and second heat sensitive elements respectively; and an infrared reflection film that is provided on the other surface of the insulating film so as to oppose to the second heat sensitive element.

In order to mount such an infrared sensor on a mounting substrate such as a circuit substrate or the like, a mounting member is utilized for supporting the infrared sensor and then mounting it on the mounting substrate while allowing electrical conduction. For example, Patent document 2 discloses an infrared sensor mounting member that is able to mount an infrared sensor body, which includes an insulating film on which a heat sensitive element and a plurality of terminal electrodes are patterned, on a substrate by fixing it on the upper portion thereof. This infrared sensor mounting member includes a mounting member main body made of a resin and a plurality of conductive terminal members that are attached to the mounting member main body with the upper end thereof being connected to the terminal electrodes while the lower end thereof being connected to the substrate when the infrared sensor mounting member is mounted thereon. In addition, the terminal members described above have terminal pin portions that are laterally projected and the mounting member main body has terminal member inserting hole portions on its side into which the terminal pin portions are inserted so as to be fixed.

### [Prior Art Documents]

### [Patent Documents]

[Patent Document 1] Japanese Unexamined Patent Application Publication 2011-102791
[Patent Document 2] Japanese Unexamined Patent Application Publication 2014-71051

### SUMMARY OF THE INVENTION

### [Problems to be solved by the Invention]

The following problems still remain in the conventional technologies described above.

Specifically, in the conventional technologies described above, the mounting member main body of the infrared sensor mounting member has a cavity that is formed for housing a thermistor. In this configuration, because the heat inside the cavity is difficult to be radiated to the outside, the heat can be accumulated there, which can disadvantageously affect the temperature measurement by the infrared sensor body.

### [Means for Solving the Problems]

The present invention has been made in view of the aforementioned circumstances, and an object of the present invention is to provide an infrared sensor mounting member that is able to effectively radiate the heat inside the cavity for housing a heat sensitive element to the outside.

The present invention adopts the following configuration in order to overcome the aforementioned problems. Specifically, an infrared sensor mounting member according to a first aspect of the present invention is able to fix an infrared sensor body, which includes an insulating substrate on which at least one heat sensitive element and a plurality of terminal electrodes are formed, at the upper portion thereof and is able to be mounted on a mounting substrate, and comprises: an insulating mounting member main body and a plurality of conductive terminal members that are attached to the mounting member main body with the upper end thereof being connected to the terminal electrodes while the lower end thereof being connected to the mounting substrate when the infrared sensor mounting member is mounted thereon, wherein the terminal members are made of a material that has a higher thermal conductivity than that of the mounting member main body and have terminal pin portions that are laterally projected, and the mounting member main body has terminal member inserting hole portions that are formed on its side into which the terminal pin portions are inserted so as to be fixed, and has an element housing hole part that is formed on the upper portion thereof and arranged directly under the heat sensitive element while being in communication with the terminal member inserting hole portions.

In this infrared sensor mounting member, since the mounting member main body has the terminal member inserting hole portions that are formed on its side into which the terminal pin portions are inserted so as to be fixed, and has the element housing hole part that is formed on the upper portion thereof and arranged directly under the heat sensitive element while being in communication with the terminal member inserting hole portions, that is, the element housing hole part as a cavity is in communication with the terminal member inserting hole portions into which the terminal pin portions are inserted, the heat inside the element housing hole part can be radiated through the terminal pin portions to the outside.

The infrared sensor mounting member according to a second aspect of the present invention is characterized by the infrared sensor mounting member according to the first aspect of the present invention, wherein the tip ends of the terminal pin portions are projected into the element housing hole part.

Specifically, in this infrared sensor mounting member, since the tip ends of the terminal pin portions are projected into the element housing hole part, the terminal pin portions that are projected into the element housing hole part so as to be exposed can function as a more effective heat radiator, leading to excellent heat radiation properties. In addition, the heat radiation characteristics can be adjusted by changing the projection amount of the tip ends of the terminal pin portions into the element housing hole part.

The infrared sensor mounting member according to a third aspect of the present invention is characterized by the infrared sensor mounting member according to the first or second aspect, wherein the element housing hole part vertically extends through the mounting member main body.

Specifically, in this infrared sensor mounting member, since the element housing hole part vertically extends through the mounting member main body, an ambient air can readily pass through the element housing hole part, and heat can be readily transmitted to the mounting substrate, and further the internal heat can be readily radiated to the outside. As a result, the temperature inside the element housing hole part can get close to an outside atmosphere temperature. In addition, this configuration can allow a visual confirmation or the like of the mounting state of the heat sensitive element through the element housing hole part from the back side.

The infrared sensor mounting member according to a fourth aspect of the present invention is characterized by the infrared sensor mounting member according to any one of the first to third aspects, wherein the mounting member main body has a thin part that is formed so as to be thinner than the other parts except the element housing hole part.

Specifically, in this infrared sensor mounting member, the mounting member main body has the thin part that is formed so as to be thinner than the other parts except the element housing hole part, the volume of the mounting member main body as well as the heat capacity thereof can be reduced, and thus the responsivity can be improved.

### [Effects of the Invention]

According to the present invention, the following effects may be provided.

Specifically, in the infrared sensor mounting member of the present invention, since the mounting member main body has the terminal member inserting hole portions that are formed on its side into which the terminal pin portions are inserted so as to be fixed, and has the element housing hole part that is formed on the upper portion thereof and arranged directly under the heat sensitive element while being in communication with the terminal member inserting hole portions, the heat inside the element housing hole part can be radiated through the terminal pin portions to the outside. Therefore, in the infrared sensor mounting member of the present invention, since the terminal pin portions are exposed into the element housing hole part or the terminal member inserting hole portions and can function as heat radiators, the heat inside the element housing hole part can be reduced and thus the responsivity can be improved, thereby allowing a correct temperature measurement to be performed.

### BRIEF DESCRIPTION OF THE DRAWINGS

FIG. 1 illustrates a plan view (a) and a cross-sectional view (b) taken along line A-A showing a state where an infrared sensor body is mounted on an infrared sensor mounting member according to one embodiment of the present invention.
FIG. 2 is a plan view of the infrared sensor mounting member according to the present embodiment.
FIG. 3 is a side view of the infrared sensor mounting member according to the present embodiment.
FIG. 4 is a back view of the infrared sensor body according to the present embodiment.
FIG. 5 illustrates a plan view (a) showing a lower metal mold and a side view (b) showing a state where the lower metal mold and an upper metal mold are assembled during a manufacturing process of the infrared sensor mounting member according to the present embodiment.
FIG. 6 is a cross-sectional view taken along line B-B in FIG. 5 showing a state where the lower metal mold and the upper metal mold are assembled.

### DESCRIPTION OF THE EMBODIMENTS

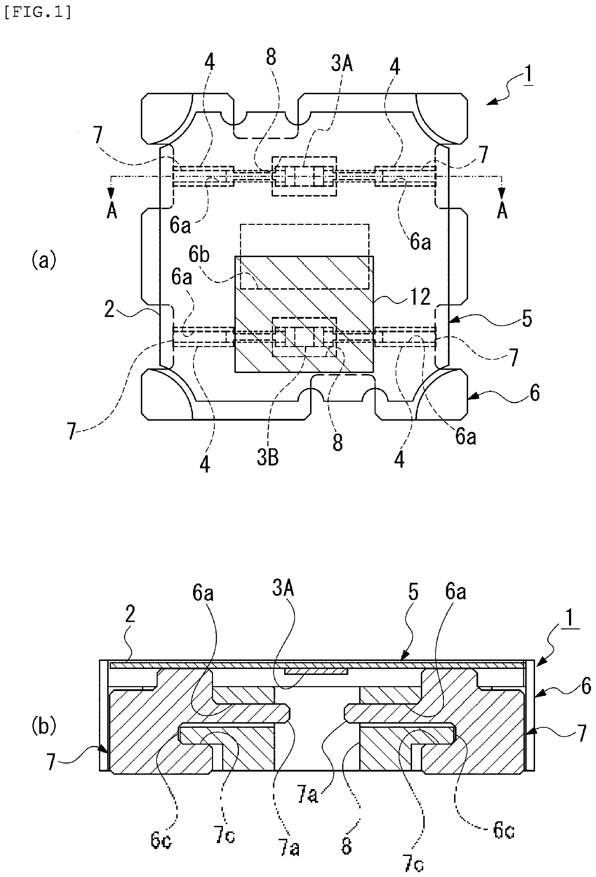

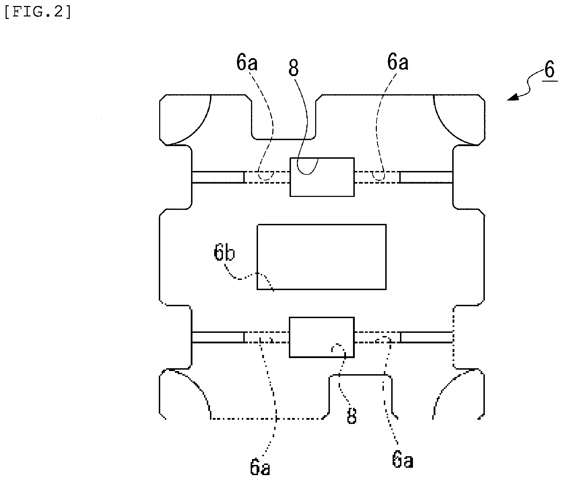

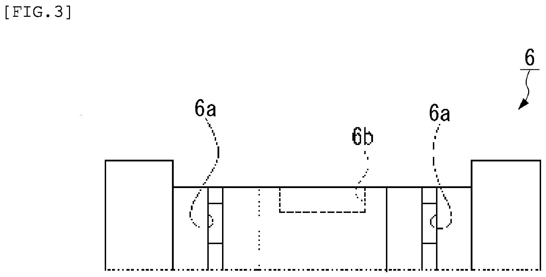

Hereinafter, an infrared sensor mounting member according to one embodiment of the present invention will be described with reference to FIGs. 1 to 6.

As shown in FIGs. 1 to 4, an infrared sensor mounting member 1 according to the present embodiment is able to mount an infrared sensor body 5, which includes an insulating substrate 2 on which first and second heat sensitive elements 3A and 3B and a plurality of terminal electrodes 4 are formed, on a mounting substrate (not shown) by fixing it on the upper portion thereof. This infrared sensor mounting member 1 includes an insulating mounting member main body 6 made of a resin or the like and a plurality of conductive terminal members 7 that are attached to the mounting member main body 6 with the upper end thereof being connected to the terminal electrodes 4 by soldering or the like while the lower end thereof being connected to the mounting substrate by soldering or the like when the infrared sensor mounting member 1 is mounted thereon.

The terminal members 7 are made of a material such as a metal or the like having a higher thermal conductivity than that of the mounting member main body 6, and have terminal pin portions 7a that are laterally projected.

The mounting member main body 6 has terminal member inserting hole portions 6a that are formed on its side into which the terminal pin portions 7a are inserted so as to be fixed, and has element housing hole parts 8 that are formed on the upper portion thereof and arranged directly under the heat sensitive elements 3A and 3B while being in communication with the terminal member inserting hole portions 6a.

Specifically, the long-projected terminal pin portions 7a can be fixed by inserting them into the terminal member inserting hole portions 6a having a long-hole shape so as to be fitted therein.

In addition, the tip ends of the terminal pin portions 7a are projected into the element housing hole parts 8.

Also, the element housing hole parts 8 vertically extend through the mounting member main body 6.

Furthermore, the mounting member main body 6 has a thin part 6b that is formed so as to be thinner than the other parts except the element housing hole parts 8. This thin part 6b is a recess formed so as to have a rectangular shape as planarly viewed at the center of the mounting member main body 6.

In the present embodiment, the mounting member main body 6 is a block shaped into a thin plate that is formed so as to have a generally square shape as planarly viewed, on which four of the terminal members 7 are installed in the vicinity of the four corners thereof with two of the terminal members 7 being allocated on its each side opposing each other. Specifically, there are two parts provided for supporting the infrared sensor body 5 so as to be spaced apart from the other two parts on each side of the mounting member main body 6, that is, the infrared sensor body 5 is supported and fixed by totally the four parts. In addition, the infrared sensor body 5 can be more stably supported and fixed by more than four of the terminal members 7 than with only four of the terminal members 7. When more than four of the terminal members 7 are employed, the added terminal(s) can be a dummy terminal(s) to which no electricity is conducted. Note that even if only four of the terminal members 7 are employed, one of four of the terminal members 7 can be a dummy terminal to which no electricity is conducted by connecting the wirings of wiring films 11A and 11B that are located on the ground side.

In addition, the infrared sensor body 5 is supported with a parallel gap being provided with respect to the mounting member main body 6. Specifically, the upper portions of the terminal members 7 are projected longer than that of the mounting member main body 6 by a predetermined amount so that the infrared sensor body 5 that is connected to the upper end thereof by soldering or the like are supported on the mounting member main body 6 in a lifted state therefrom.

The terminal members 7 have terminal slit portions 7c that extend under the terminal pin portions 7a in an opposite direction therefrom, and the mounting member main body 6 has portions inserted into the terminals (here after referred to as "terminal insertion portions") 6c that are inserted into the terminal slit portions 7c.

In addition, a convex portion may be formed anywhere on the terminal pin portions 7a for preventing them from being falling out.

The terminal slit portions 7c are formed by making cutouts in the terminal members 7 in a transverse direction so that the terminal insertion portions 6c can be inserted.

The lower ends of the terminal members 7 are located more inside than both sides of the mounting member main body 6 when the terminal members 7 are attached to the mounting member main body 6, and therefore the assembled structure is configured to be hardly inclined as a whole.

The upper and lower ends of the terminal members 7 are flat for soldering.

In addition, the terminal members 7 have a plate shape formed by die-cutting, etching, or laser processing from a metal plate. Note that the etching for creating the terminal members 7 so as to have a predetermined shape from a metal plate with an etchant or the laser processing for cutting out the terminal members 7 so as to have a predetermined shape from a metal plate with laser beam irradiation allows microfabrication with high precision compared with die-cutting.

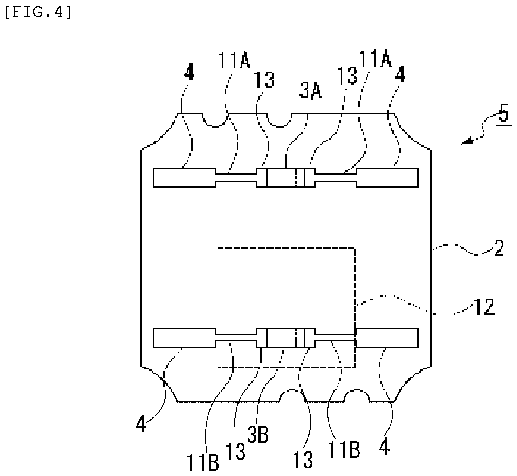

As shown in FIG. 4, the infrared sensor body 5 includes the insulating substrate 2; the first and second heat sensitive elements 3A and 3B that are provided so as to be spaced apart from each other on one surface (lower surface) of the insulating substrate 2; pairs of first and second wiring films 11A and 11B that are connected to the first and second heat sensitive elements 3A and 3B respectively, both of which are conductive metal films formed on the one surface of the insulating substrate 2; and an infrared reflection film 12 that is provided on the other surface of the insulating substrate 2 so as to oppose to the second heat sensitive element 3B.

In FIG. 1, the infrared reflection film 12 is indicated by hatching.

Each pair of the first and second wiring films 11A and 11B is connected to a pair of adhesive electrodes 13 that is formed on the insulating substrate 2 at one end thereof and is connected to the terminal electrodes 4 that are formed on the insulating substrate 2 at the other end thereof.

In addition, to the adhesive electrodes 13 are adhered the respectively corresponding terminal portions of the first and second heat sensitive elements 3A and 3B by a conductive adhesive such as solder or the like.

The insulating substrate 2 is made of an insulating film such as a polyimide resin sheet or the like while the infrared reflection film 12 and the first and second wiring films 11A and 11B are made of a copper foil. Specifically, these elements compose a double-sided flexible substrate in which the infrared reflection film 12 and the float electrodes of the copper foil serving as the first and second wiring films 11A and 11B are patterned on both sides of the polyimide substrate serving as the insulating substrate 2.

The infrared reflection film 12 has a generally square shape and is arranged directly above the second heat sensitive element 3B.

This infrared reflection film 12 is made of a material having a higher infrared reflectance than that of the insulating substrate 2 and is formed by coating a gold plating film on a copper foil. Note that a mirror finished aluminum vapor-deposited film, aluminum foil, or the like may be employed other than the gold plating film, for example. This infrared reflection film 12 is formed so as to have a larger size than that of the second heat sensitive element 3B in order to cover it.

The first and second heat sensitive elements 3A and 3B are chip thermistors having terminal portions formed at both ends thereof. Such thermistors include NTC-type, PTC-type, CTR-type thermistors, and the like, but in the present embodiment, a NTC-type thermistor is employed for the first and second heat sensitive elements 3A and 3B, for example. This thermistor is made of a Mn-Co-Cu or Mn-Co-Fe based thermistor material, or the like.

The element housing hole part 8 is a through-hole having a space that can house the first and second heat sensitive elements 3A and 3B. Note that although the element housing hole part 8 is preferably a through-hole vertically extending through the mounting member main body 6, but it may be a bottomed hole.

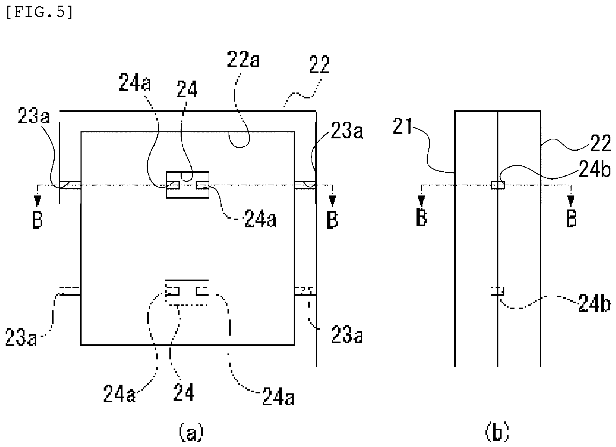

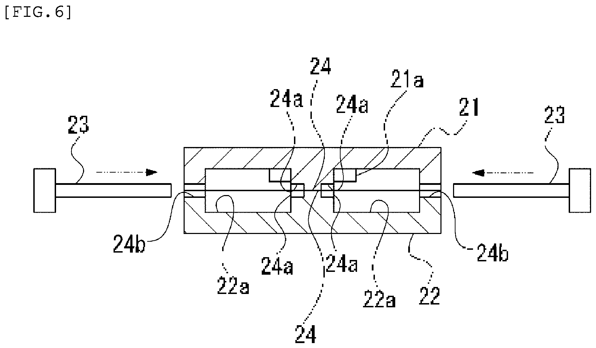

Next, a manufacturing process of the infrared sensor mounting member 1 according to the present embodiment will be described below with reference to FIGs. 5 and 6.

As shown in FIGs. 5 and 6, the manufacturing process of the infrared sensor mounting member 1 according to the present embodiment includes a molding step for forming the mounting member main body 6 by injection molding where a resin is injected into a cavity 22a that is formed between upper and lower metal molds 21 and 22, and a terminal attaching step for attaching the terminal members 7 to the terminal member inserting hole portions 6a.

In the molding step, injection molding is performed in such a manner that pin-shaped movable metal molds 23 corresponding to the shape of the terminal member inserting hole portions 6a are placed in the cavity 22a and the tip ends of the pin-shaped movable metal molds 23 are held by pin holding portions that are provided on at least one of the upper and lower metal molds 21 and 22.

In addition, at least one of the upper and lower metal molds 21 and 22 has hole part forming convex portions 24 having a shape corresponding to that of the element housing hole parts 8. Note that, in the present embodiment, the hole part forming convex portions 24 are provided on both of the upper and lower metal molds 21 and 22 so that the parts to be used for forming the element housing hole parts 8 are defined by butting the upper and lower hole part forming convex portions 24.

The pin holding portions 24a are formed in the hole part forming convex portions 24.

Note that, in the present embodiment, one of the pin holding portions 24a is formed on each of the opposed surfaces of the upper and lower hole part forming convex portions 24 that are formed on the upper and lower metal molds 21 and 22.

In the molding step described above, injection molding is performed in such a manner that the tip ends of the pin-shaped movable metal molds 23 are brought up to the position of the pin holding portions 24a in the hole part forming convex portions 24 and the tip ends of the pin-shaped movable metal molds 23 are supported by being sandwiched between the pin holding portions 24a in the upper and lower hole part forming convex portions 24 on the upper and lower metal molds opposing each other. Specifically, the molding is performed in such a manner that the tip ends of the pin-shaped movable metal molds 23 are projected to the position where the element housing hole parts 8 are to be formed during the molding step and the tip ends of the pin-shaped movable metal molds 23 are held by the pin holding portions 24a that are provided on the molding metal molds (the upper and lower metal molds 21 and 22).

In addition, each of the upper and lower metal molds 21 and 22 has base end holding portions 24b for holding the base ends of the pin-shaped movable metal molds 23. Therefore, the pin-shaped movable metal molds 23 are supported by the upper and lower metal molds 21 and 22 at both of the tip and base ends thereof during injection molding.

Furthermore, the upper metal mold 21 has a thin part forming convex portion 21a having a shape corresponding to that of the thin part 6b. Note that the thin part forming convex portion having a shape corresponding to that of the thin part 6b may be provided on the lower metal mold 22 and therefore the thin part 6b may be formed on the bottom surface of the mounting member main body 6.

After the molding step described above, the pin-shaped movable metal molds 23 are removed to leave the terminal member inserting hole portions 6a, which are in communication with the element housing hole parts 8. Then, the terminal members 7 are attached to the mounting member main body 6 by inserting the terminal pin portions 7a into the terminal member inserting hole portions 6a thus formed so as to fabricate the infrared sensor mounting member 1.

As described above, in the infrared sensor mounting member 1 according to the present embodiment, since the mounting member main body 6 has the terminal member inserting hole portions 6a that are formed on its side into which the terminal pin portions 7a are inserted so as to be fixed, and has the element housing hole parts 8 that are formed on the upper portion thereof and arranged directly under the heat sensitive elements 3A and 3B while being in communication with the terminal member inserting hole portions 6a, that is, the element housing hole parts 8 as cavities are in communication with the terminal member inserting hole portions 6a into which the terminal pin portions 7a are inserted, the heat inside the element housing hole parts 8 can be radiated through the terminal pin portions 7a to the outside.

In addition, the heat radiation characteristics can be adjusted by changing the projection amount of the tip ends of the terminal pin portions 7a into the element housing hole parts 8.

In addition, since the tip ends of the terminal pin portions 7a are projected into the element housing hole parts 8, the terminal pin portions 7a that are projected into the element housing hole parts 8 so as to be exposed can function as more effective heat radiators, leading to excellent heat radiation properties.

In addition, since the element housing hole parts 8 vertically extend through the mounting member main body 6, ambient air can readily pass through the element housing hole parts 8, and heat can be readily transmitted to the mounting substrate, and further the internal heat can be readily radiated to the outside. As a result, the temperature inside the element housing hole parts 8 can get close to an outside atmosphere temperature. In addition, this configuration can allow a visual confirmation or the like of the mounting state of the heat sensitive elements 3A and 3B through the element housing hole parts 8 from the back side.

Furthermore, since the mounting member main body 6 has the thin part 6b that is formed so as to be thinner than the other parts except the element housing hole parts 8, the volume of the mounting member main body 6 as well as the heat capacity thereof can be reduced, and thus the responsivity can be improved.

The technical scope of the present invention is not limited to the aforementioned embodiment, but the present invention may be modified in various ways without departing from the scope or teaching of the present invention.

For example, in the embodiment described above, although a chip thermistor is employed for the first and second heat sensitive elements, a thin film thermistor may be employed for the first and second heat sensitive elements.

In addition, although a thin film thermistor or chip thermistor is employed for the heat sensitive elements as described above, a pyroelectric element or the like may also be employed other than the thermistor.

### [Reference Numerals]

1: infrared sensor mounting member, 2: insulating substrate, 3A: first heat sensitive element, 3B: second heat sensitive element, 4: terminal electrode, 5: infrared sensor body, 6: mounting member main body, 6a: terminal member inserting hole portion, 6b: thin part, 7: terminal member, 7a: terminal pin portion, 8: element housing hole part

## Claims

1. An infrared sensor mounting member that is able to fix an infrared sensor body, which includes an insulating substrate on which at least one heat sensitive element and a plurality of terminal electrodes are formed, at the upper portion thereof and is able to be mounted on a mounting substrate, the infrared sensor mounting member comprising:
an insulating mounting member main body; and
a plurality of conductive terminal members that are attached to the mounting member main body with the upper end thereof being connected to the terminal electrodes while the lower end thereof being connected to the mounting substrate when the infrared sensor mounting member is mounted thereon,
wherein the terminal members are made of a material that has a higher thermal conductivity than that of the mounting member main body and have terminal pin portions that are laterally projected, and
the mounting member main body having:
terminal member inserting hole portions that are formed on its side into which the terminal pin portions are inserted so as to be fixed; and
an element housing hole part that is formed on the upper portion thereof and arranged directly under the heat sensitive element while being in communication with the terminal member inserting hole portions.

2. The infrared sensor mounting member according to claim 1, wherein the tip ends of the terminal pin portions are projected into the element housing hole part.

3. The infrared sensor mounting member according to claim 1, wherein the element housing hole part vertically extends through the mounting member main body.

4. The infrared sensor mounting member according to claim 1, wherein the mounting member main body has a thin part that is formed so as to be thinner than the other parts except the element housing hole part.
